Europäisches Patentamt

European Patent Office

Office européen des brevets

(19)

(11) Veröffentlichungsnummer: **0 256 229 B1**

(12) **EUROPÄISCHE PATENTSCHRIFT**

(45) Veröffentlichungstag der Patentschrift: **15.04.92**

(21) Anmeldenummer: **87107629.5**

(22) Anmeldetag: **26.05.87**

Die Akte enthält technische Angaben, die nach dem Eingang der Anmeldung eingereicht wurden und die nicht in dieser Patentschrift enthalten sind.

(51) Int. Cl.⁵: **G01D 5/244**, G01D 5/36, G01D 3/02

(54) **Schaltungsanordnung für eine Positionsmesseinrichtung.**

(30) Priorität: **02.08.86 DE 3626334**

(43) Veröffentlichungstag der Anmeldung:
**24.02.88 Patentblatt 88/08**

(45) Bekanntmachung des Hinweises auf die Patenterteilung:
**15.04.92 Patentblatt 92/16**

(84) Benannte Vertragsstaaten:
**DE FR GB IT**

(56) Entgegenhaltungen:

**ELEKTRO-OPTISCHER BEWEGUNGSWAND-LER, Band 101, Nr. 11, Seite 681; "Elektro-optischer Bewegungswandler"**

**U. TIETZE et al.: "Halbleiter-Schaltungstechnik", Korrigierter Nachdruck der dritten Auflage, Springer 1976, Berlin, DE**

**PATENT ABSTRACTS OF JAPAN, Band 10, Nr. 102 (P-448)[2159], 18 April 1986; & JP-A-60 236 175 (NIPPON DENKI K.K.) 22-11-1985**

**Tietkze, Schenk, "Halbleiter-Schaltungstechnik", 5. Auflage, Springer 1980, Berlin, DE, S. 27, 103-105, 266-269, 276-279, 289-291**

(73) Patentinhaber: **Dr. Johannes Heidenhain GmbH**
**Dr.-Johannes-Heidenhain-Strasse 5 Postfach 1260**
**W-8225 Traunreut(DE)**

(72) Erfinder: **Schmitt, Walter, Ing. (grad.)**
**Hochgernstrasse 22**
**W-8225 Traunreut(DE)**
Erfinder: **Zacek, Johann**
**Sonnleitenstrasse 5**
**W-8091 Evinhausen(DE)**

## Beschreibung

Die Erfindung bezieht sich auf eine Code-Meßeinrichtung mit einer Schaltungsanordnung gemäß dem Oberbegriff des Anspruches 1.

Photoelektrische Positionsmeßeinrichtungen weisen eine Maßverkörperung auf, die eine Meßteilung trägt. Die Meßteilung kann bei einer inkrementalen positionsmeßeinrichtung als Gitterteilung ausgebildet sein. Bei einer absoluten Positionsmeßeinrichtung besteht die Meßteilung im allgemeinen aus einer Anzahl von Codespuren mit unterschiedlicher Auflösung. Daher bezeichnet man absolute Positionsmeßeinrichtungen auch als Code-Meßeinrichtungen.

Derartige Code-Meßeinrichtungen sind in der Firmendruckschrift "Betriebsanleitung ROC-dual 15/63.2 Code-Drehgeber" der Firma Dr. Johannes Heidenhain GmbH, Traunreut, Dezember 1971, beschrieben.

Zur Positionsmessung wird die Meßteilung lichtelektrisch abgetastet. Dabei wird eine Abtasteinrichtung relativ zur Meßteilung verschoben. Ein Lichtsender beleuchtet die Meßteilung durch die das Licht moduliert wird. Ein Abtastelement empfängt das modulierte Licht und wandelt es in ein elektrisches Signal um, das einer Auswerteeinrichtung zu-geführt wird. Jeder Spur einer Code-Meßeinrichtung ist ein derartiger "Abtast-Signalkanal" zugeordnet. Zweckmäßigerweise dimensioniert man Abtast-Signalkanäle so, daß sie ungefähr die gleiche Grenzfrequenz aufweisen.

Durch die Grenzfrequenz und die Frequenz der Abtastsignale der feinsten Spuren wird die obere Grenze der zulässigen Meßgeschwindigkeit bestimmt. Dies hängt mit den Tiefpaßeigenschaften des jeweiligen Abtastelementes zusammen. Diese Tiefpaßeigenschaften der einzelnen Abtast-Signalkanäle bewirken mit steigender Frequenz der Abtastsignale zunehmende Phasenfehler zwischen den einzelnen Abtastsignalen und zusätzlich Amplitudenänderungen.

Beide Einflüsse stören vorwiegend bei den Signalen der feineren Spuren, weil diese neben der höchsten Frequenz in der Regel auch die geringsten Amplituden haben. Die Abtast-Signalkanäle weisen in Abhängigkeit ihrer Beschaltung auch eine gewisse Hysterese auf, die sich besonders negativ auf die Signale der feinsten Spuren auswirkt.

Vor allem durch die Tiefpaßeigenschaften des Abtast-Signalkanals kommt es zu einem Verlauf des Phasenganges des Abtastsignales in Abhängigkeit von der Frequenz, die dem Verlauf einer arc tg-Funktion angenähert ist.

Das Verhalten und die Eigenschaften von Tiefpässen sind in dem Buch "Halbleiter-Schaltungstechnik" von U. Tietze, Ch. Schenk, 5. Auflage, Springer 1980, Berlin, DE, S. 27, 103-105, 266-269, 276-279, 289-291 beschrieben.

Der Erfindung liegt die Aufgabe zugrunde, demgegenüber den Verlauf des Phasenganges zu linearisieren und die frequenzabhängigen Einflüsse von Hysterese und Offset der Schaltung im jeweiligen Abtast-Signalkanal zu minimieren.

Diese Aufgabe wird durch eine Code-Meßeinrichtung mit einer Schaltungsanordnung gemäß den Merkmalen des unabhängigen Anspruches 1 gelöst. Vorteilhafte Ausgestaltungen sind den abhängigen Ansprüchen zu entnehmen.

Die Vorteile der erfindungsgemäßen Schaltung bestehen darin, daß mit einfachen Maßnahmen und Mitteln die Abhängigkeit des Phasenganges von der Frequenz der Abtastsignale nahezu linearisiert wird und die negativen Einflüsse von Hysterese und Offset der nachfolgenden Schaltung auf ein unbedeutendes Maß reduziert werden.

Mit Hilfe der Zeichnungen soll die Erfindung anhand von Ausführungsbeispielen noch näher erläutert werden.

Es zeigt

Figur 1     den Phasengang des Abtastsignals in Abhängigkeit von der Frequenz,

Figur 2     eine Schaltung zur Linearisierung des Phasenganges und

Figur 3     eine besonders vorteilhafte Schaltung zur Linearisierung des Phasenganges.

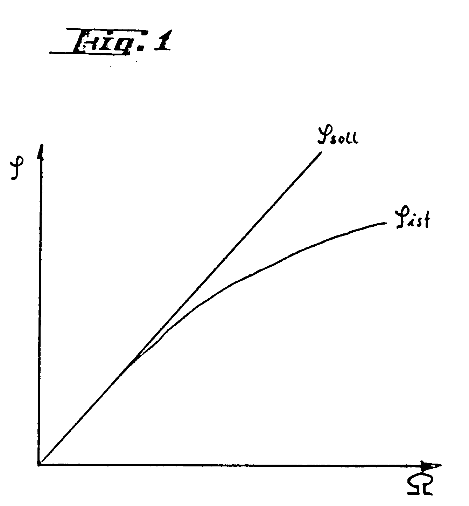

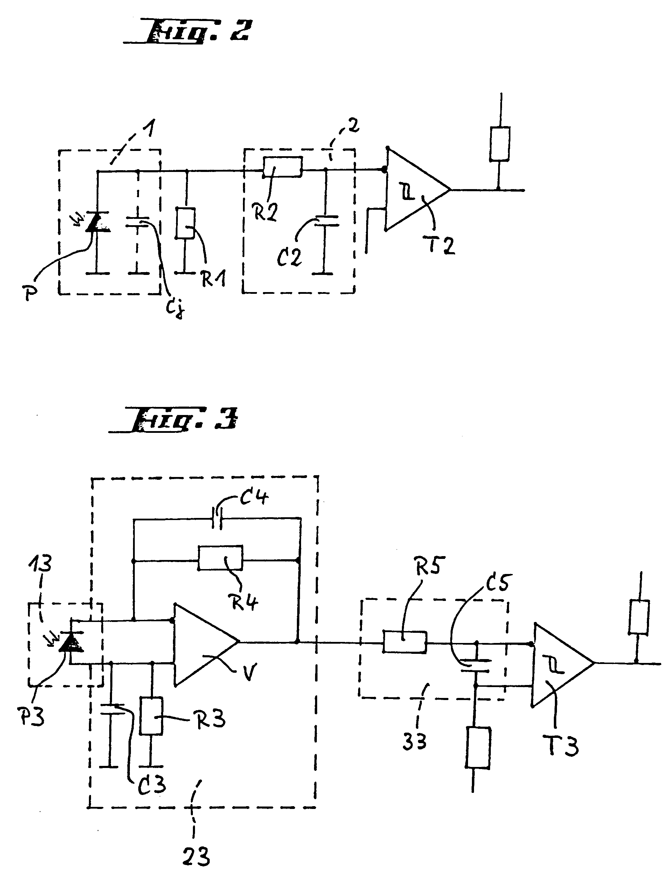

In dem Schaubild der Figur 1 ist sowohl der tatsächliche als auch der idealisierte Phasengang $\phi$ des Abtastsignaes in Abhängigkeit von der normierten Frequenz Groß-Omega schematisch dargestellt. Unter der normierten Frequenz Groß-Omega versteht man das Verhältnis der Frequenz Klein-Omega zu der Frequenz Klein-Omega-Null, wobei Klein-Omega-Nul die Grenzfrequenz ist. Die Gerade $\phi$ soll stellt den idealen Phasengang dar. Der tatsächliche Phasengang $\phi$ ist entsteht durch den Eingangstiefpaß (s. Figur 2) am Abtastelement 1 wegen der Kapazität $C_j$ des Photoelementes P in Verbindung mit dem Arbeitswiderstand R1. Dem Abtastelement 1 ist ein Tiefpaß 2 nachgeschaltet, der aus einem Kondensator C2 und einem Widerstand R2 besteht.

Der Tiefpaß 2 ist hinsichtlich seiner Grenzfrequenz so ausgelegt, daß der Phasengang $\phi$ weitgehend linearisiert wird. Die Kurve $\phi$ ist nähert sich also stark der Geraden $\phi$ soll gemäß Figur 1 an.

In Figur 3 ist eine besonders vorteilhafte Ausgestaltung der Erfindung dargestellt. Auch hier ist ein Eingangstiefpaß 13 aufgrund der nicht dargestellten Kapazität des Photoelements P3 vorhanden. Dem Photoelement P3 ist ein Tiefpaß 23 nachgeschaltet, der neben den üblichen RC-Gliedern R3, R4, C3, C4 einen Verstärker V enthält. Vorzugsweise wird ein Photoelementverstärker mit Differenzeingang verwendet.

Dieser mit dem Verstärker V versehene Tiefpaß 23 ermöglicht neben der Phasengangkompensation gleichzeitig eine Amplitudenanhebung des Abtastsignales.

Zur Optimierung der Schaltung ist ein weiteres Laufzeitglied in Form eines Tiefpasses 33 vorgesehen, der aus dem Widerstand R5 und dem Kondensator C5 gebildet wird. Durch den Verstärker V sind die Tiefpässe 23 und 33 voneinander entkoppelt, so daß sich die Grenzfrequenzen der einzelnen Tiefpässe 23 und 33 nicht gegenseitig beeinflussen.

Die Grenzfrequenzen der Tiefpässe lassen sich auf diese Weise so abstimmen, daß sogar die frequenzabhängigen Einflüsse von Hysterese und Offset der nachfolgenden Triggerschaltungen T2 bzw. T3 auf ein unbedeutendes Maß reduziert werden können.

Zweckmäßigerweise dimensioniert man alle Signalkanäle mit gleicher Grenzfrequenz. Dadurch erreicht man, daß Laufzeitglieder nur bei den Abtast-Signalkanälen erforderlich werden, bei denen die maximal auftretende Signalfrequenz größer als ca. 1/4 der Grenzfrequenz ist.

Es versteht sich, daß als Laufzeitglieder nicht nur die gezeigten Tiefpässe 2, 23, 33 geeignet sind, son dern daß auch sogenannte Allpaß-Schaltungen und digitale Laufzeitschaltungen in erfindungsgemäßer Weise eingesetzt werden können.

**Patentansprüche**

1. Code-Meßeinrichtung mit einer Schaltungsanordnung für die Auswertung von Abtastsignalen mit unterschiedlich hohen Abtastsignal-Frequenzen, bei der lichtelektrisch mehrere Teilungsspuren unterschiedlich hoher Auflösung abgetastet werden und bei der Abtastsignal-Kanäle Tiefpaßverhalten aufweisen, dadurch gekennzeichnet, daß wenigstens einem Abtast-Photoelement (P, P3) eines Abtastsignal-Kanals, bei dem die maximal auftretende Signalfrequenz größer als ca. 1/4 der Grenzfrequenz genannter Abtastsignal-Kanäle ist, wenigstens ein Laufzeitglied (2,23,33) nachgeschaltet ist.

2. Code-Meßeinrichtung nach Anspruch 1, dadurch gekennzeichnet, daß das Laufzeitglied (23) einen Verstärker (V) aufweist.

3. Code-Meßeinrichtung nach Anspruch 2, dadurch gekennzeichnet, daß dem den Verstärker (V) aufweisenden Laufzeitglied (23) ein weiteres Laufzeitglied (33) nachgeschaltet ist.

4. Code-Meßeinrichtung nach den Ansprüchen 1 bis 3, dadurch gekennzeichnet, daß die Laufzeitglieder (2, 23, 33) als Tiefpässe mit sogenannten RC-Netzwerken ausgeführt sind.

**Claims**

1. Code measuring device with a circuit arrangement for evaluation of scanner signals with different scanner signal frequencies, in which several division traces of different resolutions are scanned photoelectrically, and in which scanner signal channels have low-pass behaviour, characterised in that at least one delay unit (2, 23, 33) is incorporated after at least one scanner photo element (P, P3) of a scanner signal channel, in which the maximum occurring signal frequency is greater than approximately 1/4 of the threshold frequency of named scanner signal channels.

2. Code measuring device according to Claim 1, characterised in that the delay unit (23) has an amplifier (V).

3. Code measuring device according to Claim 2, characterised in that a further delay unit (33) is incorporated after the delay unit (23) having the amplifier (V).

4. Code measuring device according to Claims 1 to 3, characterised in that the delay units (2, 23, 33) are constructed as low-pass filters with so-called RC-networks.

**Revendications**

1. Dispositif de mesure à code comportant un circuit pour l'exploitation de signaux de lecture de fréquence plus ou moins élevée, dans lequel plusieurs traits de graduation de définition plus ou moins élevée sont lus par voie photo-électrique et dans lequel des canaux de signaux de lecture se comportent en filtres passe-bas, caractérisé en ce qu'au moins un élément de retard (2, 23, 33) est branché à la suite d'au moins une cellule photo-électrique de lecture (P, P3) d'un canal de signal de lecture, dans lequel la fréquence de signal maximale apparaissant est supérieure à environ 1/4 de la fréquence limite desdits canaux de signaux de lecture.

2. Dispositif de mesure à code selon la revendication 1, caractérisé en ce que l'élément de retard (23) comporte un amplificateur (V).

3. Dispositif de mesure à code selon la revendication 2, caractérisé en ce qu'un élément de retard (33) supplémentaire est branché à la suite de l'élément de retard (23) qui comporte l'amplificateur (V).

4. Dispositif de mesure à code selon les revendications 1 à 3, caractérisé en ce que les éléments de retard (2, 23, 33) sont réalisés sous forme de filtres passe-bas avec des circuits RC.

_Fig. 1_

# Fig. 2

# Fig. 3